# EUROPÄISCHE PATENTANMELDUNG

(11) **EP 0 999 594 A1**
(43) Veröffentlichungstag der Anmeldung: **10.05.2000**
(21) Anmeldenummer: 99121901.5
(22) Anmeldetag: 05.11.1999
(51) Int. Cl.: H01L 27/088, H01L 29/78, H01L 29/10, H01L 29/167, H01L 21/8234, H01L 21/336, H01L 21/265

(54) **Integrierte Schaltung mit MOS-Feldeffekttransistoren, die mit Stickstoff dotierte Bereiche aufweisen, und Verfahren zu deren Herstellung**

(30) Priorität: 06.11.1998 DE 19851313
(71) Anmelder: Infineon Technologies AG, 81541 München (DE)
(72) Erfinder: Schumann, Dirk, 01097 Dresden (DE)
(74) Vertreter: Zedlitz, Peter

(57) **Zusammenfassung**

Der Anmeldungsgegenstand betrifft eine integrierte Schaltung mit mindestens zwei MOS-Feldeffekttransistoren mit unterschiedlich langen Kanalbereichen, deren Schwellenspannungen dadurch weitgehend gleich groß sind, daß Dotierungsüberhöhungen an den Kanalrändern, die durch Source-/Drain-Implantationsschäden am Kanalrand hervorgerufen werden und den sogenannten Reserve Short Channel Effekt verursachen, durch eine gewinkelte Stickstoffimplantation vermieden werden.

## Beschreibung

Die Erfindung betrifft integrierte MOS-Schaltungen mit kleinen Transistorlängen, zum Beispiel unter 0,5 µm, bei denen ein sogenannter Revers Short Channel Effect auftritt. Dabei handelt es sich um ein Ansteigen der Einsatz- oder Schwellenspannung bei Verkleinerung der Kanallänge. Ursache dafür ist eine Dotierstoffanhäufung an den Kanalrändern in der Nähe der Source-/Drain-Gebiete. Diese Dotierstoffanhäufung wird in erster Linie durch Source-/Drain-Implantationsschäden am Kanalrand hervorgerufen. Die Einsatzspannung kann zwischen einem 10 µm langen Transistor und einem Transistor mit einer Länge von weniger als 0,5 µm um mehr als 100 mV ansteigen. Dies kann insbesondere für das analoge Schaltungsdesign, in dem verschiedene Transistorlängen in diesem Bereich auftreten, sehr störend sein.

Bei heutigen CMOS-Prozessen wird versucht, diesen Effekt dadurch zu reduzieren, daß die Source-/Drain-Implantationsschäden durch einen sogenannten RTP (Rapid Termal Process) reduziert werden. Unter Rapid Termal Process versteht man ein Tempern bei 800 bis 1000°C für eine Zeitdauer von 5 bis 10 Sekunden.

Dies gelingt jedoch nur unvollständig und hat außerdem den Nachteil, daß dadurch das gesamte thermische Budget des CMOS-Prozesses erhöht wird, das heißt, daß durch die zusätzliche thermische Belastung die Source-/Drain- und Kanalprofile verbreitert werden können.

Aus einem IEEE-Paper zur IEDM 95, 34.4.1 bis 34.4.4, Seiten 859 bis 862, ist eine Stickstoffimplantation in ein Gateoxid in der Nähe von Kantenabdeckungen (Spacer) bekannt, wodurch durch eine lokale Reduzierung der Dotierungskonzentration parasitäre Widerstände im Transistor in ihrem Wert erhöht werden.

Die der Erfindung zugrundeliegende Aufgabe besteht nun darin, einen integrierten MOS-scchaltkreis und ein zugehöriges Herstellungsverfahren anzugeben, bei dem unterschiedlich lange Transistoren möglichst die gleiche Einsatzspannung aufweisen, ohne eine zusätzliche thermische Belastung im Herstellungsprozeß.

Die Erfindung ist nachfolgend anhand eines in den Zeichnungen dargestellten Ausführungsbeispiels näher erläutert. Dabei zeigt
- Figur 1: ein Dotierungsprofil eines MOS-Feldeffekttransistors zur Erläuterung der Erfindung,
- Figur 2: ein Diagramm zur Verdeutlichung der unterschiedlichen Abhängigkeit der Schwellenspannung von der Kanallänge und
- Figuren 3a bis 3d: Schnittdarstellungen zur Erläuterung des Herstellverfahrens.

Die Erfindung beruht im wesentlichen darauf, daß durch eine gewinkelte Stickstoffimplantation vor der Erzeugung der Spacer und des letzten Implantationsschritts zur Erzeugung der Source-/Drain-Gebiete eine Dotierstoffüberhöhung im Bereich der Kanalränder durch Besetzung von Diffusionspfaden mit Stickstoffatomen vermieden wird.

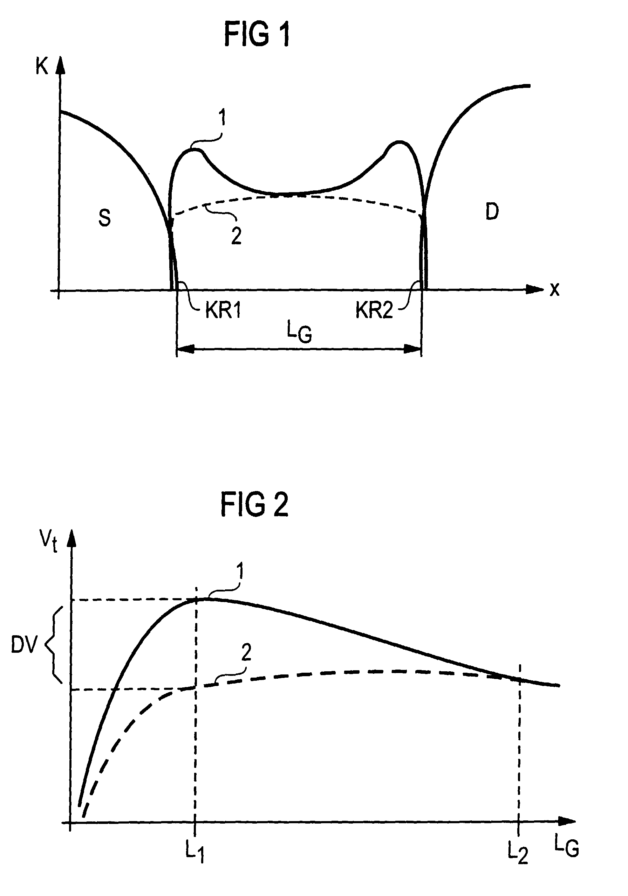

In Figur 1 ist ein Dotierstoffprofil mit den Konzentrationen K über der Länge x zwischen einem Sourcegebiet S und einem Draingebiet D aufgetragen. Zwischen dem Sourcegebiet S und dem Draingebiet D erstreckt sich ein Kanalgebiet der Länge L_{G}. Zwischen einem ersten Kanalrand KR1 und einem zweiten Kanalrand KR2 ist ein Dotierprofil 1 mit einer deutlichen Überhöhung in der Nähe der Kanalränder KR1 und KR2 dargestellt, das einem Dotierprofil bei üblichen MOS-Feldeffekttransistoren entspricht. Darüber hinaus ist zwischen den Kanalrändern KR1 und KR2 ein Dotierprofil 2 gestrichelt dargestellt, das keine Überhöhung im Bereich der Kanalränder aufweist und dem Dotierprofil eines erfindungsgemäßen Transistors entspricht. Hieraus wird ebenfalls deutlich, daß die mittlere Dotierstoffkonzentration im Falle des Dotierprofils 2 weitgehend gleich bleibt, wenn die Kanallänge L_{G} verkleinert wird.

In Figur 2 wird die Schwellenspannung Vₜ in Abhängigkeit der Kanallänge L_{G} für die beiden Dotierprofile 1 und 2 dargestellt. Hieraus wird deutlich, daß im Falle der Erfindung, also beim Dotierprofil 2, bei großen Kanallängen L2 annähernd die gleiche Schwellenspannung wie bei kleinen Kanallängen L1 auftritt. Bei bekannten Transistoren, also beim Dotierungsprofil 1, tritt bei einer Verkleinerung der Kanallänge L2 auf L1 ein Schwellenspannungsunterschied DV auf, der typischerweise bei etwa 100 mV bis 120 mV liegt.

Diese Aufgabe wird erfindungsgemäß hinsichtlich der integrierten Schaltung durch die Merkmale des Patentanspruchs 1 und hinsichtlich des Herstellverfahrens durch Anspruch 2 gelöst. Die weiteren Ansprüche betreffen vorteilhafte Ausbildungen der Erfindung.

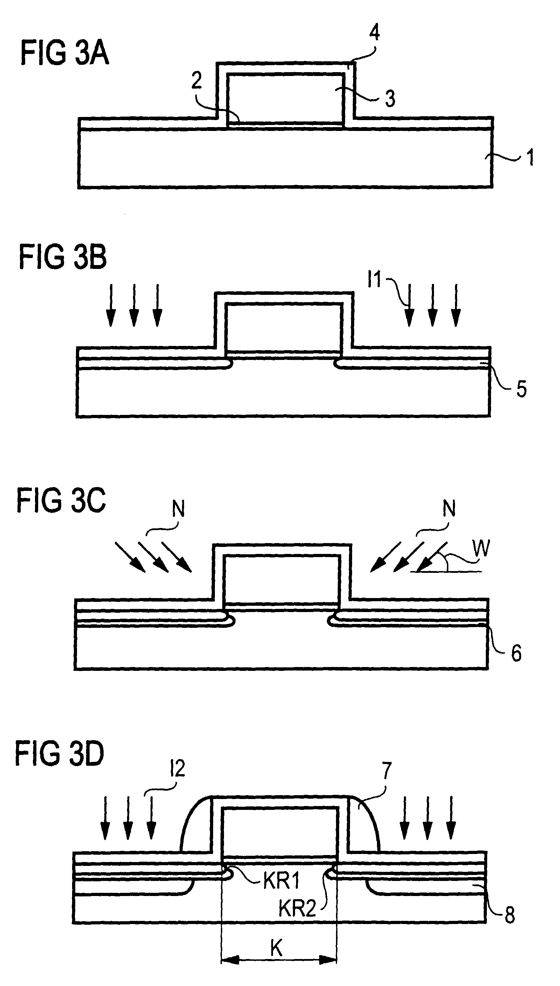

In Figur 3a ist ein Siliziumgrundkörper 1 dargestellt auf dem durch ein Gateoxid 2 getrennt ein Gate 3 vorhanden ist, wobei der Siliziumgrundkörper und auch das Gate durch eine Siliziumdioxidschicht 4 bedeckt ist. In Figur 3b wird, in einem ersten Schritt, durch eine erste Implantation I1, beispielsweise mit Arsen, eine sogenannte Extensionsschicht 5 erzeugt. Diese Extensionsschicht 5 befindet sich in einem oberflächennahen Bereich des Halbleiterkörpers 1 und reicht bis an die Kanalränder KR1 und KR2. In Figur 3c ist nun, in einem zweiten Schritt, eine gewinkelte Stickstoffimplantation N unter einem Winkel W angedeutet, die einen als Stickstoffpocket bezeichneten, im Halbleiterkörper unterhalb der Extensionsschicht befindlichen Bereich 6 erzeugt, der etwas weiter als die Extensionsschicht in den Kanalbereich K hineinreicht. Der Winkel W und die Implantationsdosis der Stickstoffimplantation N ist dabei vorteilhafterweise so zu wählen, daß die Extensionsschicht 5 innerhalb des Halbleiterkörpers weitgehend von der Schicht 6 umhüllt wird.

Die Implantationsdosis liegt typischerweise bei ca. 5 . 10¹³ ... 2 . 10¹⁴ cm⁻² und der Winkel W beträgt typischerweise kleiner gleich 30°.

In Figur 3d sind letzte Verfahrensschritte dargestellt, bei denen nach der Stickstoffimplantation Kantenabdeckungen oder Ätzresiduen 7 (Spacer) erzeugt werden und danach HDD-Implantationen (high density donator implantation), beispielsweise mit Arsen, und nachfolgende Ausheilschritte erfolgen und auf diese Weise die restlichen Bereiche 8 der Source- und Drain-Bereiche S und D erzeugt werden.

## Patentansprüche

1. Integrierte Schaltung mit mindestens zwei MOS-Feldeffekttransistoren mit unterschiedlich langen Kanalbereichen (K) und mit jeweiligen Source- und Drain-Gebieten (S, D), die mit Stickstoff (N) dotierte Bereiche (6) enthalten, die lateral weiter in den jeweiligen Kanalbereich (K) reichen als die restlichen Bereiche (5, 8) der Source- und Drain-Gebiete.

2. Verfahren zur Herstellung einer integrierten Schaltung mit mindestens zwei MOS-Feldeffekttransistoren mit unterschiedlich langen Kanalbereichen (K) zwischen Source- und Drain-Gebieten (S, D), bei dem vor einer Erzeugung einer Kanalabdeckung (7) an Rändern (KR1, KR2) der Kanalbereiche (K) und einer letzten Dotierung zur Erzeugung der Source- und Drain-Gebiete eine Stickstoffimplantation (N) in den Halbleiterkörper unter einem Winkel (W) verschieden von 90° erfolgt.

3. Verfahren nach Anspruch 2,
bei dem die Dotierungskonzentration und der Winkel so gewählt wird, daß ein, durch eine erste Dotierung vor der Stickstoffimplantation erzeugter, Bereich der Source- und Drain-Gebiete (5) von einem durch die Stickstoffimplantation erzeugten dotierten Bereich (6) im Halbleiterkörper weitgehend umgeben ist, wobei der stickstoffdotierte Bereich etwas in den Kanalbereich hineinreicht als der vor der Stickstoffimplantation erzeugte Bereich.

4. Verfahren nach Anspruch 2 oder 3,
bei dem der Winkel (W) kleiner gleich 30° beträgt.
